(19) Europäisches Patentamt
European Patent Office
Office européen des brevets

(11) **EP 2 426 545 A1**

(12) **EUROPEAN PATENT APPLICATION**
published in accordance with Art. 153(4) EPC

(43) Date of publication:
**07.03.2012 Bulletin 2012/10**

(51) Int Cl.:
***G02B 27/48*** *(2006.01)*    ***G02B 27/18*** *(2006.01)*
***G03B 21/14*** *(2006.01)*

(21) Application number: **10769566.0**

(22) Date of filing: **15.03.2010**

(86) International application number:
**PCT/JP2010/054289**

(87) International publication number:
**WO 2010/125866 (04.11.2010 Gazette 2010/44)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **27.04.2009 JP 2009107472**

(71) Applicant: **Konica Minolta Opto, Inc.
Hachioji-shi
Tokyo 192-8505 (JP)**

(72) Inventor: **UCHINO Hiroshi
Hino-shi
Tokyo 191-8511 (JP)**

(74) Representative: **HOFFMANN EITLE
Patent- und Rechtsanwälte
Arabellastraße 4
81925 München (DE)**

(54) **IMAGE DISPLAY APPARATUS AND LASER PROJECTION APPARATUS**

(57)    An object of the present invention is to provide a technique capable of, in an image display apparatus and a laser projection apparatus that reduce speckle noise by means of high-frequency superimposition, reducing a deterioration in the light emission intensity of a semiconductor laser while suppressing EMI. To achieve the object, the image display apparatus includes a plurality of semiconductor lasers for emitting laser beams of different wavelengths in accordance with drive currents supplied thereto, a laser-drive circuit for generating the drive currents by superimposing a plurality of high-frequency signals on image signals of a plurality of color components, respectively, and deflection means for deflecting each of the laser beams, wherein the plurality of high-frequency signals have different fundamental frequencies.

F I G . 1

**Description**

TECHNICAL FIELD

The present invention relates to an image display apparatus that displays an image using a laser beam.

BACKGROUND ART

A display using a laser as a light source can reproduce natural colors with a wider color range, as compared with using a discharge lamp as the light source. Particularly, a laser-beam scan type projector requires no projection optical system, and therefore can be downsized as compared with a method of using a projection optical system to project an illumination light modulated by a two-dimensional spatial modulation device such as a liquid crystal panel or a DMD (digital micromirror device).

The laser-beam scan type projector can also reduce power consumption, because it changes the amount of light emission from a light source in accordance with the luminance of a pixel to be displayed, such as stopping the light emission from the light source in a case of displaying a black pixel. In this manner, the laser-beam scan type projector has excellent features as a display device, and is attracting attention as a next-generation high-quality display.

On the other hand, a laser display has a problem specific thereto that due to a high coherence of the laser beam, non-uniformity of the luminance on a viewing surface occurs to cause eye flickering called speckle noise (hereinafter also referred to as "speckle"), so that a person viewing the displayed image suffers discomfort and eye strain. Thus, a reduction in the speckle noise is one of technical problems involved in practical use of the laser display.

There are generally two methods for reducing speckle noise. In first one of the methods, a generated speckle pattern is changed over time, and a plurality of patterns being overlapped on one another are shown by utilizing an afterimage effect of human eyes, to thereby average the non-uniformity of the luminance and thus reduce the speckle noise.

According to Patent Document 3 that adopts the first method, in a rear-projection type television using a laser beam as a light source, a screen is rotated in parallel with a viewing surface, to thereby change a speckle pattern over time and thus reduce speckle noise.

In second one of the methods for reducing speckle noise, a plurality of polarization states are overlapped on one another or a plurality of wavelengths are overlapped on one another, to thereby reduce a coherence of a light emitted from a light source and thus reduce speckle noise.

According to Patent Document 1 and Patent Document 2 that adopt the second method, a single-mode semiconductor laser (also referred to as "LD", "laser diode", or the like) is used as a laser light source, and the LD is used in a multi-mode by using a relaxation oscillation that occurs at a time when a drive current of the LD having a high-frequency signal superimposed thereon exceeds an oscillation threshold current so that the LD starts light emission. In this method, a light-emission wavelength interval is increased by causing the LD to emit a light in the multi-mode, to thereby reduce a coherence of a laser beam emitted from the LD and thus reduce speckle noise.

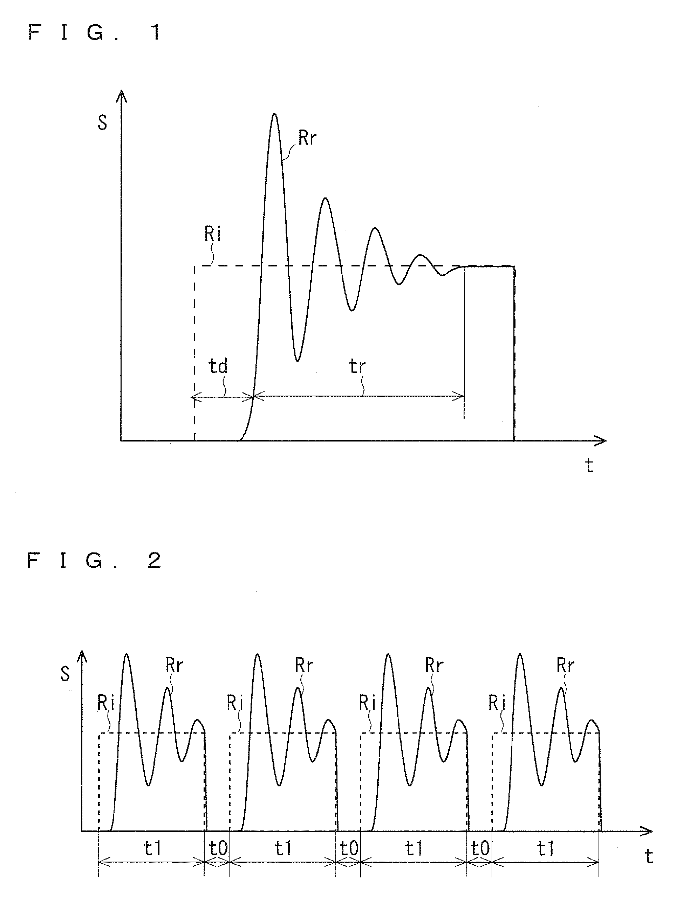

FIG. 1 shows an example of transient response characteristics in a case where the LD is driven by a square-wave current. In FIG. 1, the horizontal axis represents a time axis t, and the vertical axis represents the number of photons S. As shown in FIG. 1, an ideal response is a square wave Ri in which the number of photons S rises simultaneously with a drive current waveform. Actually, however, the LD starts light emission after elapse of an oscillation delay time period *td,* and a waveform *Rr* of the number of photons S repeats a vibration called a relaxation oscillation, and then converges to its steady-state value. Here, a time period *tr* for which the relaxation oscillation is sustained is referred to as a relaxation oscillation duration.

The oscillation delay time period *td* normally changes within a range of approximately 0 to 5 nsec due to a bias current of the LD prior to the rise of the drive current of the LD, and becomes shorter as the bias current is closer to the oscillation threshold current. Since a shorter oscillation delay time period *td* is more preferable, the bias current is normally brought closer to the oscillation threshold current and the LD is driven such that the oscillation delay time period *td* can fall within a range of 0 to 1 nsec. Normally, the relaxation oscillation duration *tr* is approximately 2 to 3 nsec. While the relaxation oscillation is occurring, the LD emits a light in the multi-mode, and when the relaxation oscillation converges, the LD emits a light in the single-mode.

Thus, it is possible that the single-mode LD repeatedly emits a light in the multi-mode, by a method in which the relaxation oscillation exhibited in the waveform *Rr* is repeatedly generated by repeatedly performing: using a drive current of a continuous square wave to cause the LD being in a light-emission stop state to emit a light; and then setting the drive current lower than the oscillation threshold current of the LD before the relaxation oscillation converges, to thereby stop the light emission from the LD.

FIG. 2 shows an example of the transient response characteristics in a case where the LD is driven by a continuous square-wave current. In FIG. 2, the vertical axis and the horizontal axis are set in the same manner as in FIG. 1.

Each of the square waves Ri shown in FIG. 2 indicates an ideal response of the number of photons S with respect to the drive current of the continuous square wave. The rise and fall of each square wave *Ri* are coincident with the rise and fall of the continuous square-wave current generated by superimposing a high-frequency signal, respectively. Therefore, in FIG. 2, the *t1* represents a time period (also referred to as "semiconductor-laser drive period" or "pulse width") during one cycle of the drive current of the LD having the high-frequency signal superimposed thereon, in which the current value of the drive current is equal to or more than the current value of the oscillation threshold current of the LD, while the *t0* represents a time period (also referred to as "semiconductor-laser non-drive period") during one cycle of the drive current of the LD having the high-frequency signal superimposed thereon, in which the current value of the drive current is less than the current value of the oscillation threshold current of the LD.

This driving method is called a high-frequency superimposition method, and widely used as a method for suppressing mode hopping noise caused by a return light in pickup of CD/DVD or the like. This is effective as a method for reducing speckle noise in a laser display, too, because a coherence of a projected laser beam is reduced due to the multi-mode.

PRIOR-ART DOCUMENTS

PATENT DOCUMENTS

Patent Document 1: Japanese Patent Application Laid-Open No. 2001-189520
Patent Document 2: Japanese Patent Application Laid-Open No. 2004-70286
Patent Document 3: Japanese Patent Application Laid-Open No. 2006-343663

SUMMARY OF THE INVENTION

PROBLEMS TO BE SOLVED BY THE INVENTION

However, the method adopted in the Patent Document 3 requires a mechanism for mechanically driving the screen, which causes problems of increased power consumption, occurrence of noise, a lowered reliability, an increased cost due to an increase in the number of component parts, and the like. In an apparatus such as a small-size portable projector (categorized as a so-called pocket projector in recent years) using no special screen, an idea of moving a screen is not possible in the first place.

In the high-frequency superimposition method adopted by the Patent Document 1 and the Patent Document 2, it is necessary that the drive current of the LD is lowered to a value equal to or less than the oscillation threshold current in each cycle of the high-frequency signal in order to generate the relaxation oscillation.

Although a shorter length of the semiconductor-laser non-drive period *t0* of the drive current of the LD is preferable because it can suppress a reduction in the light intensity, the drive current of the LD in a laser projector is approximately a few hundred mA and therefore it is difficult, in terms of circuit design, to extremely shorten the length of the semiconductor-laser non-drive period *t0*. In actual designing, nominally, a time period of about 1 nsec is required.

In this manner, performing the high-frequency superimposition creates a time period in which the light emission from the LD is stopped, thus reducing an average amount of light emission from the LD. The reduction in the amount of light emission leads to a reduction in the maximum luminance of an image that is displayed using a single LD, and therefore is a problem in a laser projector requiring a high light intensity.

Here, a ratio *r* of a time period in which the LD emits a light is calculated by the expression (1) using the semiconductor-laser drive period *t1* and the semiconductor-laser non-drive period *t0* of the drive current of the LD, and the oscillation delay time period *td* of the LD.

[Math. 1]

$$r = (t1 - td) / (t1 + t0) \qquad \ldots (1)$$

In order to suppress a reduction in the amount of light emission, the frequency of the high-frequency signal superimposed by the high-frequency superimposition is lowered to thereby increase the length of the semiconductor-laser drive period *t1* of the drive current, thus increasing the ratio *r* of the time period in which the LD emits a light.

However, in a case where the frequency of the high-frequency signal superimposed by the high-frequency superimposition is lowered so that the semiconductor-laser drive period $t1$ of the drive current becomes longer than the sum of the oscillation delay time period $td$ and the relaxation oscillation duration $tr$ and thus exceeds the relaxation oscillation duration $tr$ to cause the LD to emit a light, the light emission from the LD is the single-mode and therefore the speckle-noise reduction effect is deteriorated. In this manner, in the high-frequency superimposition method, a trade-off relationship is established between the speckle-noise reduction effect and the amount of light emission from the LD.

Moreover, in the laser projector, since a high light intensity is required, the drive current of the LD is large, too. Thus, the high-frequency superimposition method involves a problem that occurrence of EMI (electromagnetic interference) due to an electromagnetic wave caused by use of a high-frequency drive current makes it impossible to satisfy the noise standard when mounting a laser projection apparatus on an equipment, and a problem that the size and the cost of the laser projection apparatus are increased by a circuit for generating the high-frequency drive current and a shield structure necessary for an anti-EMI product.

Particularly, in an apparatus including a plurality of LDs, such as a color projector, if respective LDs of a laser projection apparatus including a plurality of LIDS are driven by a drive current having the same frequency as in Patent Document 1, the peak of EMI becomes large at a fundamental frequency thereof and each harmonic frequency thereof. This consequently causes a problem that, when the laser projection apparatus is mounted on an image display apparatus or the like, the noise standard cannot be satisfied or alternatively a shield structure or the like serving as an anti-EMI member is required, which increases the cost.

Therefore, an object of the present invention is to provide an image display apparatus and a laser projection apparatus that reduce speckle noise by using high-frequency superimposition and that can suppress EMI while reducing a deterioration in the light emission intensity of a semiconductor laser.

MEANS FOR SOLVING THE PROBLEMS

To solve the above-described problems, an image display apparatus according to a first aspect includes: a plurality of semiconductor lasers for emitting laser beams of different wavelengths in accordance with drive currents supplied thereto; a laser-drive circuit for generating the drive currents by superimposing a plurality of high-frequency signals on image signals of a plurality of color components, respectively; and deflection means for deflecting each of the laser beams. In the image display apparatus, the plurality of high-frequency signals have different fundamental frequencies.

An image display apparatus according to a second aspect is the image display apparatus according to the first aspect, in which for the plurality of semiconductor lasers, a semiconductor-laser drive period of each of the drive currents is set so as to monotonically increase sequentially from ones of the plurality of semiconductor lasers in which the sum of an oscillation delay time period and a relaxation oscillation duration is shorter.

An image display apparatus according to a third aspect is the image display apparatus according to the first aspect, in which for the plurality of semiconductor lasers, a semiconductor-laser drive period of each of the drive currents is set so as to be equal to the sum of an oscillation delay time period and a relaxation oscillation duration.

An image display apparatus according to a fourth aspect is the image display apparatus according to the first aspect, in which for the plurality of semiconductor lasers, a semiconductor-laser drive period of each of the drive currents is set so as to monotonically increase sequentially from one of the plurality of semiconductor lasers that emits the laser beam having a wavelength to which human's luminosity factor is higher.

An image display apparatus according to a fifth aspect is the image display apparatus according to the first aspect, in which the plurality of high-frequency signals have different harmonic frequencies from one another in a range up to a predetermined-order harmonic.

A laser projection apparatus according to a sixth aspect is a laser projection apparatus for projecting a laser beam, including: a plurality of semiconductor lasers for emitting laser beams of different wavelengths in accordance with drive currents supplied thereto; and a laser-drive circuit for generating the drive currents by superimposing a plurality of high-frequency signals on image signals of a plurality of color components, respectively. In the laser projection apparatus, the plurality of high-frequency signals have different fundamental frequencies.

A laser projection apparatus according to a seventh aspect is a laser projection apparatus for projecting a laser beam, including: a plurality of semiconductor lasers for emitting laser beams of different wavelengths in accordance with drive currents supplied thereto; and a laser-drive circuit for generating each of the drive currents that serve as cycle signals, such that a semiconductor-laser drive period of each of the drive current can be equal to the sum of an oscillation delay time period and a relaxation oscillation duration corresponding to each of the plurality of semiconductor laser. In the laser projection apparatus, each of the drive currents is generated based on a high-frequency signal and an image signal corresponding to each of the plurality of semiconductor lasers, and the drive currents have different cycles.

EFFECTS OF THE INVENTION

In the image display apparatus according to any of the first to fifth aspects and in the laser projection apparatus according to the sixth aspect, the plurality of high-frequency signals to be superimposed on the image signals of the plurality of color components for generating the drive currents of the plurality of semiconductor lasers by the laser-drive circuit have different fundamental frequencies. As a result, spectrums of EMIs caused based on the fundamental frequencies of the high-frequency signals when the plurality of semiconductor lasers are driven can be dispersed to lower a peak value of the EMI, so that the EMI can be efficiently suppressed.

In the image display apparatus according to the second aspect, for the plurality of semiconductor lasers, the semiconductor-laser drive period of each of the drive currents of the plurality of semiconductor lasers is set so as to monotonically increase sequentially from one of the plurality of semiconductor lasers in which the sum of the oscillation delay time period and the relaxation oscillation duration is shorter. This can efficiently suppress speckle noise while reducing a deterioration in the light emission intensity.

In the image display apparatus according to the fourth aspect, for the plurality of semiconductor lasers, the semiconductor-laser drive period of each of the drive currents of the plurality of semiconductor lasers is set so as to monotonically increase sequentially from one of the plurality of semiconductor lasers that emits the laser beam having a wavelength to which human's luminosity factor is higher. This can efficiently suppress visual speckle noise while reducing a deterioration in the light emission intensity.

In the laser projection apparatus according to the seventh aspect, the semiconductor-laser drive period of each of the drive currents that serve as cycle signals to be supplied to the plurality of semiconductor lasers is equal to the sum of the oscillation delay time period and the relaxation oscillation duration corresponding to each of the plurality of semiconductor lasers, and the drive currents have different cycles. This can efficiently suppress speckle noise while dispersing spectrums of EMIs caused by the respective drive currents to thereby lower a peak value of the EMI.

BRIEF DESCRIPTION OF THE DRAWINGS

[FIG. 1] A diagram showing an example of response characteristics of an LD responsive to an input of a square wave.

[FIG. 2] A diagram showing an example of response characteristics of the LD responsive to an input of a continuous square wave.
[FIG. 3] A block diagram showing an outline of an exemplary functional configuration of an image projection apparatus according to an embodiment.
[FIG. 4] A block diagram showing an outline of an exemplary functional configuration of a light-source drive section according to the embodiment.
[FIG. 5] A block diagram showing an outline of a functional configuration of an LD drive circuit according to the embodiment.
[FIG. 6] A diagram partially showing an example of a signal waveform in a laser-drive circuit according to the embodiment.
[FIG. 7] A diagram showing an outline of an exemplary functional configuration of an optical mechanism section according to the embodiment.
[FIG. 8] A diagram showing an example of response characteristics of the LD responsive to an input of a square wave.
[FIG. 9] A diagram showing an example of response characteristics of the LD responsive to an input of a square wave.
[FIG. 10] A diagram showing an example of response characteristics of the LD responsive to an input of a square wave.
[FIG. 11] A diagram for explaining the human's spectral luminous efficiency with respect to various wavelengths of lights.

EMBODIMENT FOR CARRYING OUT THE INVENTION

<Outline Configuration of Image Projection Apparatus>

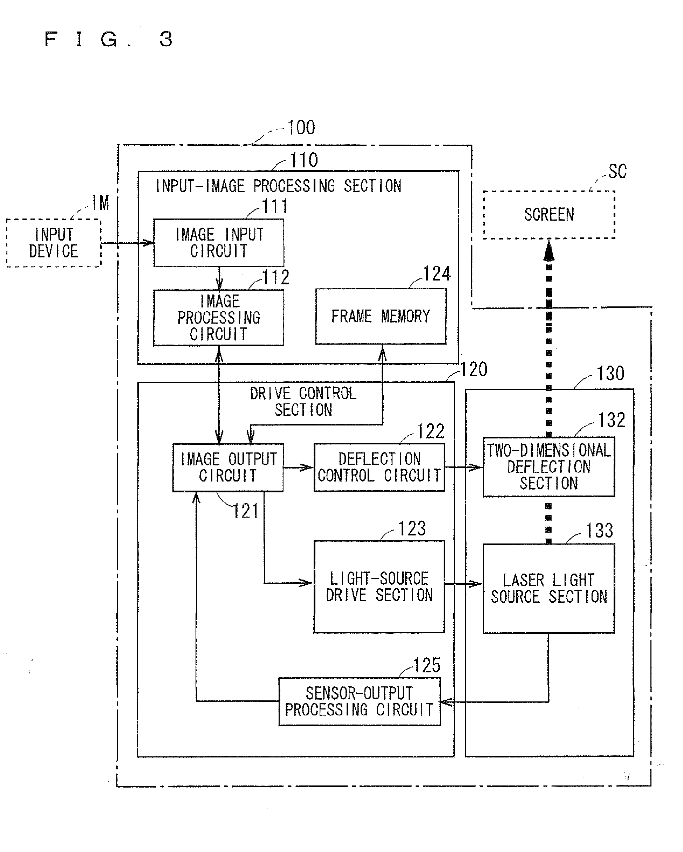

FIG. 3 is a block diagram showing an exemplary functional configuration of an image projection apparatus 100 according to an embodiment of the present invention.

The image projection apparatus 100 is an apparatus for projecting a moving image to a screen SC serving as a projection surface, and mainly includes an input-image processing section 110, a drive control section 120, and an optical mechanism section 130. The image projection apparatus 100 is equivalent to the "image display apparatus" of the invention of the present application.

The input-image processing section 110 includes an image input circuit 111, an image processing circuit 112, and a frame memory 124. The image input circuit 111 receives an image signal inputted from an input device IM, and outputs it to the image processing circuit 112. The image processing circuit 112 appropriately performs image processing such as digitalization on the image signal supplied from the image input circuit 111, and outputs a resulting signal to an image output circuit 121 of the drive control section 120 (which will be described later). The image signal outputted to the image output circuit 121 is written into the frame memory 124 by the image output circuit 121.

Here, examples of the input device IM include a personal computer (PC), and examples of the image signal include a general NTSC signal. Examples of the image processing performed by the image processing circuit 112 include general γ-correction processing and processing of changing the order of pixel values in a case where a change of the order of scanning pixels is required.

The drive control section 120 includes the image output circuit 121, a deflection control circuit 122, a light-source drive section 123, and a sensor-output processing circuit 125.

The image output circuit 121 reads out the image signal from the frame memory 124, and in response to a horizontal synchronization signal and a vertical synchronization signal of the image signal, outputs to the deflection control circuit 122 a signal (also referred to as "deflection control signal") for controlling a timing of driving a two-dimensional deflection section 132, and also outputs to the light-source drive section 123 a signal (also referred to as "pixel data signal") corresponding each color component (red, green, and blue) of a pixel value of the image signal, a signal (also referred to as "frequency setting signal") for setting a frequency (fundamental frequency) of a fundamental wave of a high-frequency signal used for high-frequency superimposition to generate a drive current of an LD of each color that emits a light of each color component, and a signal (also referred to as "bias-current setting signal") for setting a bias current of the LD of each color. The pixel data signal, the frequency setting signal, and the bias-current setting signal will be further described later.

The image output circuit 121 receives an output signal (which will be described later) from the sensor-output processing circuit 125, and in accordance with the strength of the output signal, adjusts the strength of the pixel data signal to be outputted to the light-source drive section 123.

The deflection control circuit 122 supplies, to the two-dimensional deflection section 132, a drive signal having a potential in accordance with the deflection control signal supplied from the image output circuit 121.

The light-source drive section 123 outputs, to each of a plurality semiconductor lasers (which will be described later) provided in a laser light source section 133, a drive current in accordance with a pixel data signal supplied from the image output circuit 121, such that the semiconductor laser can emit a light whose color and luminance are in accordance with a tone corresponding to the pixel data signal supplied from the image output circuit 121. This output operation is performed in response to the horizontal synchronization signal and the vertical synchronization signal of the image signal.

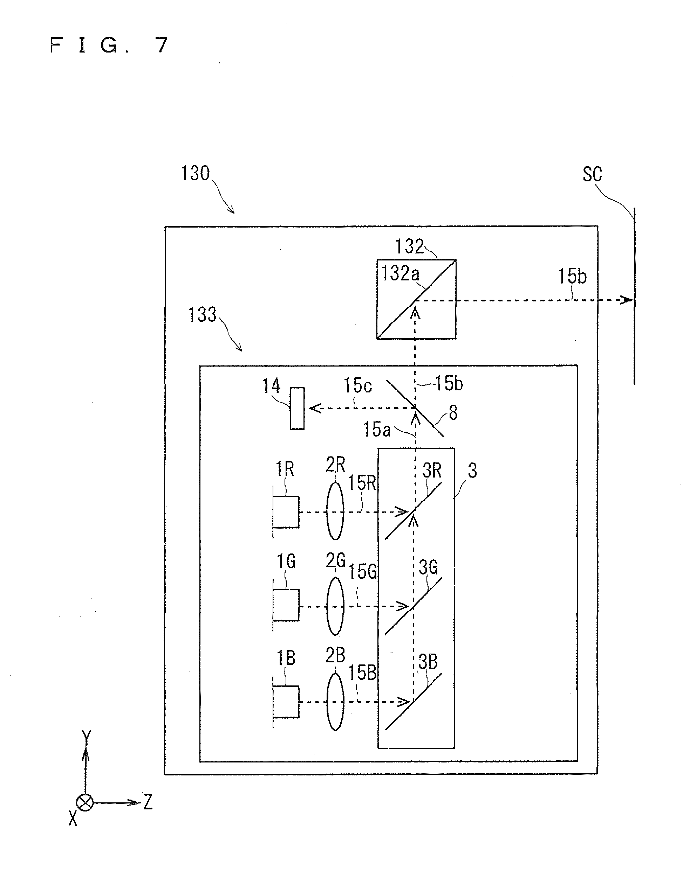

The sensor-output processing circuit 125 performs necessary processes such as an amplification process on the output signal outputted from a light-receiving element 14 (FIG. 7) of the laser light source section 133, and outputs a resulting signal to the image output circuit 121.

The input-image processing section 110 and the drive control section 120 may be functionally implemented by a CPU reading and executing a predetermined program, or alternatively may be configured as a special electronic circuit.

The optical mechanism section 130 includes the two-dimensional deflection section 132 and the laser light source section 133.

The laser light source section 133 has a plurality of semiconductor lasers that emit laser beams of the respective colors of red, green, and blue. The laser light source section 133 outputs to the two-dimensional deflection section 132 a laser beam whose color and luminance are in accordance with a tone corresponding to the pixel data signal supplied from the image output circuit 121, and also outputs to the sensor-output processing circuit 125 an electrical signal in accordance with the intensity of each laser beam.

The two-dimensional deflection section 132 has a part (reflection part) that reflects a luminous flux of a laser beam emitted from the laser light source section 133. The reflection part rotates around two substantially perpendicular axes, to thereby deflect the luminous flux emitted from the laser light source section 133 in a two-dimensionally reflecting manner, so that the luminous flux is guided onto the screen SC serving as the projection surface, thus projecting a moving image on the screen SC.

Here, the light-source drive section 123 and the laser light source section 133 correspond to a "laser projection apparatus" of the present invention. In FIG. 3, a laser beam traveling from the laser light source section 133 through the two-dimensional deflection section 132 to the screen SC is expressed by the arrow of thick broken line. A specific configuration of the optical mechanism section 130 including the two-dimensional deflection section 132 and the laser light source section 133 will be further described later.

In this manner, the image projection apparatus 100, the input device IM, and the screen SC configure an image projection system that outputs an image data supplied from the input device IM such that the image data can be visible on the screen SC.

<Outline Configuration of Light-Source Drive Section>

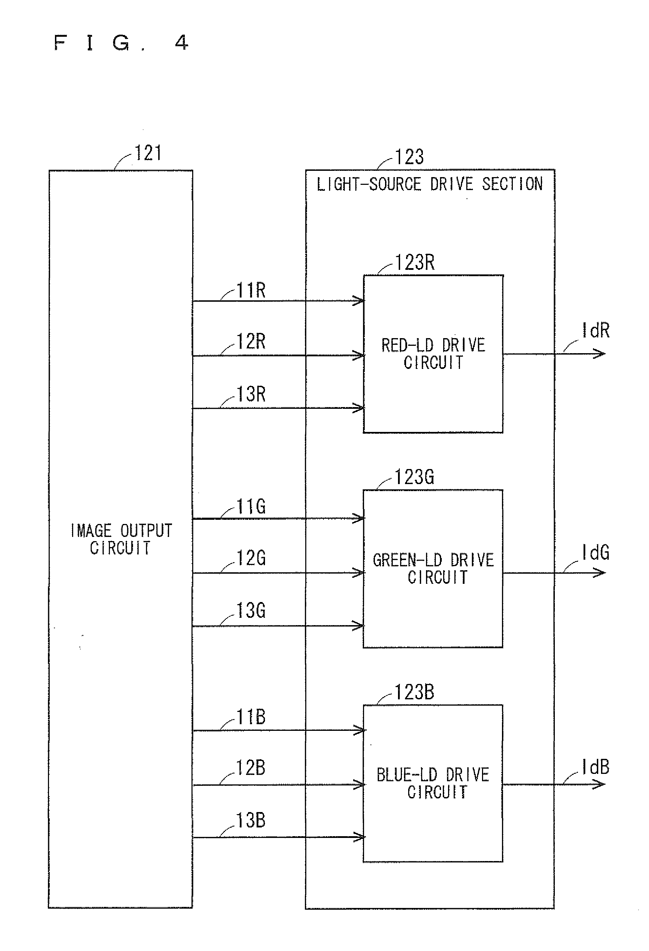

FIG. 4 is a block diagram showing an outline of an exemplary functional configuration of the light-source drive section 123 according to the embodiment of the present invention.

The light-source drive section 123 is a circuit for supplying a drive current to each of the semiconductor lasers 1R, 1G, and 1B (FIG. 7) of the laser light source section 133, and mainly includes a red-LD drive circuit 123R, a green-LD drive circuit 123G, and a blue-LD drive circuit 123B. The light-source drive section 123 corresponds to a "laser-drive circuit" of the present invention.

The image output circuit 121 supplies, to the red-LD drive circuit 123R, a pixel data signal 11R corresponding to the red color component of the pixel value of the image signal, and a frequency setting signal 12R and a bias-current setting signal 13R. corresponding to the semiconductor laser 1R.

Likewise, the image output circuit 121 supplies, to the green-LD drive circuit 123G, a pixel data signal 11G corresponding to the green color component of the pixel value of the image signal, and a frequency setting signal 12G and a bias-current setting signal 13G corresponding to the semiconductor laser 1G.

Thus, the image output circuit 121 supplies, to the blue-LD drive circuit 123B, a pixel data signal 11B corresponding to the blue color component of the pixel value of the image signal, and a frequency setting signal 12B and a bias-current setting signal 13B corresponding to the semiconductor laser 1B.

Based on the pixel data signal, the frequency setting signal, and the bias-current setting signal thus supplied, the red-LD drive circuit 123R, the green-LD drive circuit 123G. and the blue-LD drive circuit 123B generates drive currents IdR, IdG, and IdB for driving the semiconductor lasers 1R, 1G, and 1B, respectively, and supply them to the semiconductor laser. Each of the drive currents IdR, IdG, and IdB corresponds to "each drive current" of the present invention.

The frequency setting signals 12R, 12G, and 12B, and the bias-current setting signals 13R, 13G, and 13B are adjustable by means of, for example, changing the setting of a DIP switch of predetermined bit provided in the image output circuit 121.

<Outline Configuration of Drive Circuit of Each Light Source>

The red-LD drive circuit 123R, the green-LD drive circuit 123G, and the blue-LD drive circuit 123B employ the same circuit configuration. Here, an outline configuration of each LD drive circuit will be described by taking the red-LD drive circuit 123R as an example.

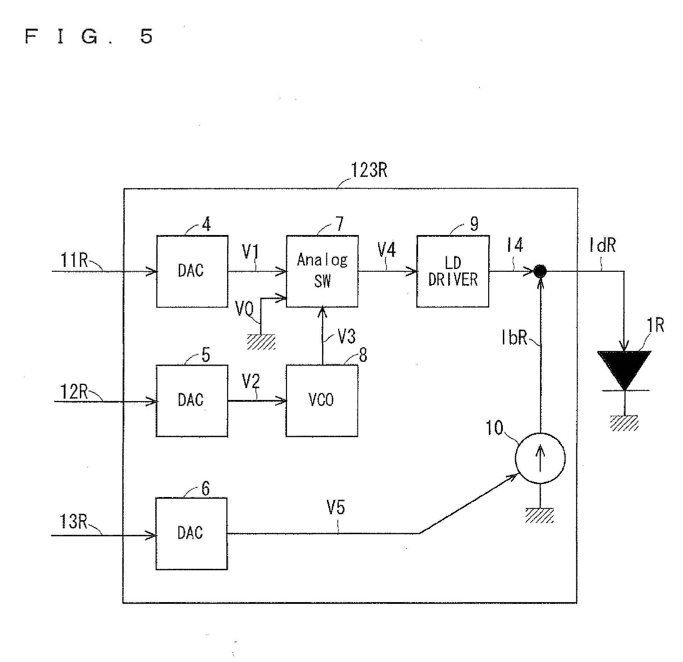

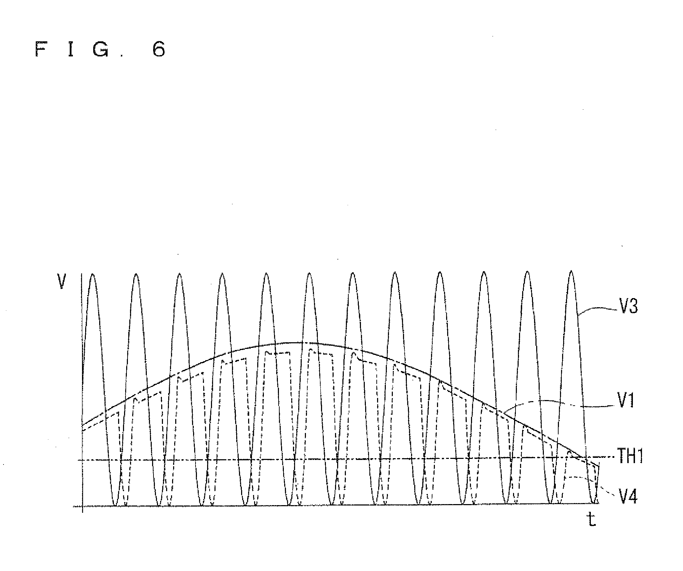

FIG. 5 is a block diagram showing an outline of an exemplary functional configuration of the red-LD drive circuit 123R, and FIG. 6 is a diagram partially showing an example of a signal waveform in the red-LD drive circuit 123R.

As shown in FIG. 5, the red-LD drive circuit 123R mainly includes D/A converters (also referred to as "DAC") 4, 5, and 6, an analog switch (also referred to as "Analog SW") 7, a voltage control oscillator (also referred to as "VCO") 8, an LD driver 9, and a bias current source 10.

The image output circuit 121 supplies the pixel data signal 11R, the frequency setting signal 12R, and the bias-current setting signal 13R to the DAC 4, 5, and 6, respectively.

By the DAC 4, the pixel data signal 11R is converted into an analog voltage V1 (FIG. 5, FIG. 6), and then inputted to the analog switch 7.

Also in the green-LD drive circuit 123G and the blue-LD drive circuit 123B, analog voltages V6 and V7 (not shown) corresponding to the analog voltage V1 are generated, respectively. Here, the analog voltages V1, V6, and V7 correspond to "a plurality of color components" of the present invention.

By the DAC 5, the frequency setting signal 12R corresponding to the semiconductor laser 1R is converted into an analog voltage V2, and then supplied to the VCO 8. In the VCO 8, a high-frequency signal V3 (FIG. 5, FIG. 6) having a fundamental frequency in accordance with the analog voltage V2 is generated and supplied to the analog switch 7. That is, the high-frequency signal V3 is a high-frequency signal associated with the semiconductor laser 1R.

Also in the green-LD drive circuit 123G and the blue-LD drive circuit 123B, high-frequency signals V8 and V9 (not shown) corresponding to the high-frequency signal V3 that are high-frequency signals associated with the semiconductor lasers 1G and 1B, respectively, are generated. Here, each of the high-frequency signals V3, V8, and V9 correspond to "a high-frequency signal" of the present invention.

The fundamental frequencies of the high-frequency signals V3, V8, and V9 can be adjusted by adjusting the frequency setting signals 12R, 12G, and 12B.

The analog switch 7 uses the high-frequency signal V3 as a control input signal, and if the high-frequency signal V3 is higher than a predetermined threshold voltage TH1 (FIG. 6) of a control input, outputs the analog voltage V1 while if the high-frequency signal V3 is lower than the threshold voltage TH1, outputs a ground ("GND")-level signal V0.

In other words, a signal V4 (FIG. 5, FIG. 6) obtained by chopping the analog voltage V1 based on the pixel data signal 11R with the fundamental frequency of the high-frequency signal V3 supplied from the VCO 8 is outputted from the analog switch 7, and supplied to the LD driver 9. Accordingly, as shown in FIG. 6, the fundamental frequency of the signal V4 has the same value as that of the fundamental frequency of the high-frequency signal V3, and the signal V4 is delayed behind the analog voltage signal V1 and the high-frequency signal V3 due to a delay in the circuit, for example.

Here, the threshold voltage TH1 can be adjusted by, for example, adjusting a resistance (not shown) that determines the value of the threshold voltage TH1, which allows adjustment of a duty cycle between an image portion of the signal V4, that is, a signal corresponding to the analog voltage V1, and a signal corresponding to the GND-level signal V0.

The LD driver 9 converts the signal V4 into a current I4 in accordance with a signal level thereof. Further, a bias current IbR (which will be described later) is added to the current 14, thus generating the drive current IdR for driving the semiconductor laser 1R. That is, the drive current IdR is a drive current that is generated by superimposing the high-frequency signal V3 associated with the semiconductor laser 1R on the analog voltage V1 and that has the same fundamental frequency as that of the high-frequency signal V3.

In the same manner, the drive currents IdG and IdB (FIG. 4) are drive currents that are generated by superimposing the high-frequency signals V8 and V9 associated with the semiconductor lasers 1G and 1B on the analog voltages V6 and V7, respectively, and that have the same fundamental frequencies as those of the high-frequency signals V8 and V9, respectively.

By the DAC 6, the bias-current setting signal 13R is converted into an analog voltage signal V5, and then inputted to the bias current source 10. The bias current source 10 outputs the bias current IbR in accordance with the inputted analog voltage signal V5. As mentioned above, the bias current IbR is added to the current I4.

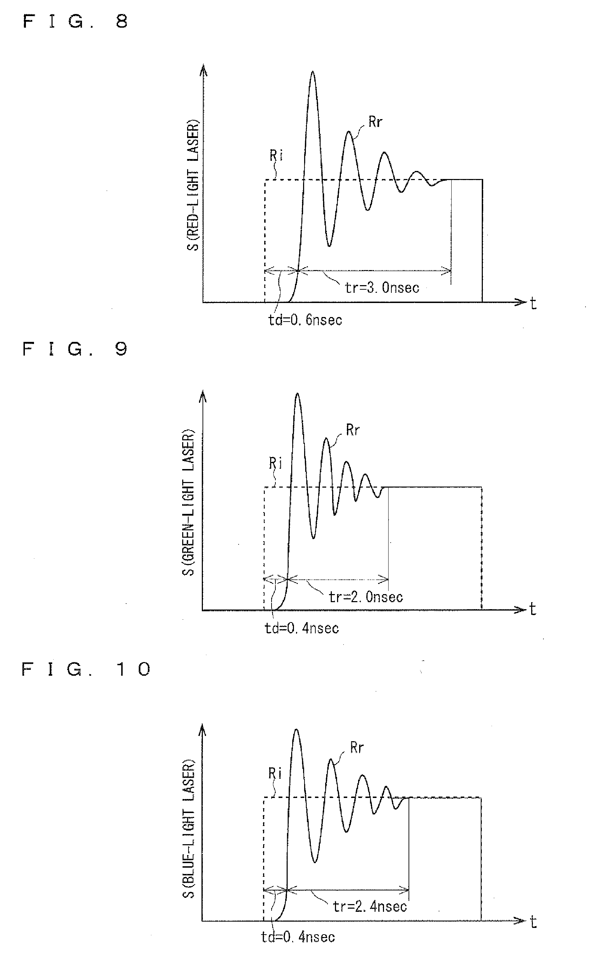

An oscillation delay time period *td* (FIG. 8) of the semiconductor laser 1R is changed by the bias current IbR. As the bias current IbR becomes lower than the oscillation threshold current of the semiconductor laser 1R, the oscillation delay time period *td* is increased to reduce an average amount of light emission from the semiconductor laser 1R.

On the other hand, when the bias current IbR exceeds the oscillation threshold current of the semiconductor laser 1R, the semiconductor laser 1R emits a light even at a black level on the image, which deteriorates an image contrast. Therefore, it is desirable to control the bias current IbR to a value as close to the oscillation threshold current as possible but within a range not exceeding the oscillation threshold current.

<Outline Configuration of Optical Mechanism Section>

FIG. 7 is a diagram showing an example of an outline configuration of the optical mechanism section 130. As shown in FIG. 7, the optical mechanism section 130 includes the two-dimensional deflection section 132 and the laser light source section 133. In FIG. 7, coordinate axes are shown for the indication of directions.

The two-dimensional deflection section 132 corresponds to "deflection means" of the present invention, and is formed of, for example, a so-called MEMS (Micro Electro Mechanical Systems) mirror which is obtained by performing microfabrication on a silicon chip. The two-dimensional deflection section 132 includes a movable part that has a plurality of piezoelectric elements, a torsion bar, and the like, and a deflection scanning mirror 132a that reflects a luminous flux emitted from the laser light source section 133.

A potential drive signal supplied from the deflection control circuit 122 in accordance with the deflection control signal causes the plurality of piezoelectric elements to expand or contract as appropriate, thus deforming the movable part, so that the deflection scanning mirror 132a rotates around the two substantially perpendicular axes (an a-axis substantially parallel to the X axis in FIG. 7 and a b-axis substantially parallel to the Y-axis in FIG. 7). As a result of this rotation, the luminous flux emitted from the laser light source section 133 is deflected in a two-dimensionally reflecting manner. In this specification, the wording "deflecting in a two-dimensional direction" is used to express a state where the reflection part rotates around the two axes to thereby change a traveling direction of the luminous flux with respect to the vertical direction and the horizontal direction independently of each other, in other words, a state where the luminous flux is deflected in the vertical direction while being also deflected in the horizontal direction.

Here, a deflection drive signal for achieving a low-speed rotation of the deflection scanning mirror 132a around the a-axis and a deflection drive signal for achieving a high-speed rotation of the deflection scanning mirror 132a around the b-axis by using resonance driving thereof are superimposed on each other and then applied to the plurality of piezoelectric elements. This allows the deflection scanning mirror 132a to simultaneously perform the low-speed rotation around the a-axis and the high-speed rotation around the b-axis using the resonance driving. Thus, by deflecting the laser beam in two different directions, horizontal scanning and vertical scanning with the laser beam can be simultaneously performed on the screen SC. Two-dimensional scanning in which the horizontal scanning and the vertical scanning are simultaneously performed using a single element is preferable in view of reducing the number of component parts of the two-dimensional deflection section 132, and also preferable in view of reducing the manufacturing cost and reducing operations required for adjustment of elements.

The laser light source section 133 includes the semiconductor lasers 1R, 1G, and 1B that emit laser beams, and a lens (collimator lens) that converts the laser beam emitted from the semiconductor laser into a substantially parallel luminous flux.

Here, the laser light source section 133 includes a pair of the semiconductor laser 1R that produces a red (R) laser beam 15R and a collimating lens that converts the laser beam 15R into a substantially parallel luminous flux, a pair of the semiconductor laser 1G that produces a green (G) laser beam 15G and a collimator lens 2G that converts the laser beam 15G into a substantially parallel luminous flux, and a pair of the semiconductor laser 1B that produces a blue (B) laser beam 15B and a collimator lens 2B that converts the laser beam 15B into a substantially parallel luminous flux. Here, each of the semiconductor lasers 1R, 1G, and 1B corresponds to a "semiconductor laser" of the present invention.

For example, semiconductor lasers that emit laser beams having wavelengths 630 nm, 532 nm, and 445 nm are adopted as the semiconductor lasers 1R, 1G, and 1B, respectively. In accordance with the drive currents IdR, IdG, and IdB supplied from the light-source drive section 123 at a timing responsive to the horizontal synchronization signal and the vertical synchronization signal of the image signal, each of the semiconductor lasers 1R, 1G, and 1B produces and emits a laser beam whose luminance corresponds to each color component (red, green, blue) of the pixel value of the image signal. For example, a semiconductor laser that emits a laser beam in an infrared region may be adopted, and a laser beam emitted from the semiconductor laser may be subjected to wavelength conversion using an SHG (second harmonic generation) element so that a visible light is emitted.

The laser beams 15R, 15G, and 15B converted into the substantially parallel luminous fluxes are, as luminous fluxes substantially in parallel with the Z-axis of FIG. 2, inputted to a combining section 3.

The combining section 3 includes a dichroic mirror 3R for reflecting the red laser beam 15R while passing lights having the other wavelengths, a dichroic mirror 3G for reflecting the green laser beam 15G while passing lights having the other wavelengths, and a dichroic mirror 3B for reflecting the blue laser beam 15B while passing lights having the other wavelengths. The dichroic mirror 3B may be an ordinary mirror that reflects any of the laser beams. Instead of each of the dichroic mirrors, a dichroic prism may be adopted, and instead of the ordinary mirror, a ordinary prism that reflects any of the laser beams may be adopted.

The position and angle of each semiconductor laser and the position and angle of each dichroic mirror of the combining section 3 are appropriately adjusted. The laser beams 15R, 15G, and 15B inputted substantially in parallel with the Z-axis to the combining section 3 are incident on the dichroic mirrors 3R, 3G, and 3B, respectively, and combined into a single luminous flux 15a substantially parallel with the Y-axis due to the function of the dichroic mirrors, and then outputted from the combining section 3, to be inputted to a branching element 8.

For example, the branching element 8 can be implemented by forming an uncoated portion in a part (for example, a central part) of a reflective mirror coating so that a luminous flux inputted to the uncoated portion can pass therethrough while a luminous flux inputted to the remaining portion can be reflected, or by applying a dielectric multilayer coating over an entire area of a substrate made of, for example, glass where a luminous flux is inputted to thereby form a semi-transmissive mirror (also referred to as a "leakage mirror") having both of transmission characteristics and reflection characteristics so that the whole of the inputted luminous flux can pass through with a predetermined transmittance while the whole of the inputted luminous flux can be reflected with a predetermined reflectance. The transmittance value and the reflectance value of the branching element 8 such as a semi-transmissive mirror are appropriately set to be 95% and 5%, respectively, for example.

In the former branching element that passes therethrough a luminous flux inputted to the uncoated portion while reflecting a luminous flux inputted to the remaining portion, the intensity distribution of a transmitted light and a reflected light is damaged in a cross-section perpendicular to the luminous flux, and the directivity of the transmitted light and the reflected light is deteriorated due to diffraction. Although this deterioration may not damage the usability of the apparatus, it is rather desirable to adopt the latter leakage mirror as the branching element 8.

The laser beam 15a inputted to the branching element 8 is branched into a laser beam 15b and a laser beam 15c. The laser beam 15b passes through the branching element 8 toward the +Y direction substantially in parallel with the Y-axis. The laser beam 15c is reflected by the branching element 8 toward the -Z direction substantially in parallel with the Z-axis.

The laser beam 15b is inputted to the two-dimensional deflection section 132, and deflected in a two-dimensional direction by the deflection scanning mirror 132a, and then projected onto the screen SC. The laser beam 15c is inputted to the light-receiving element 14 that outputs an electrical signal in accordance with the intensity of the laser beam 15c, then converted into an electrical signal, and outputted to the sensor-output processing circuit 125.

Examples of the light-receiving element 14 include a photodiode of current-output type, and a photodetector sensor of current-output type or voltage-output type. The sensor-output processing circuit 125 of the image projection apparatus 130 is provided with a current-voltage converter, an amplifier, or the like, in accordance with a sensor adopted as the light-receiving element 14.

<Frequency Selection Method>

Next, a description will be given of response characteristics of the semiconductor laser at a time of high-frequency superimposition, and a method for selecting a frequency of the high-frequency signal suitable for the response characteristics. FIGS. 8, 9, and 10 are diagrams showing examples of response characteristics, responsive to an input of a square wave, of the semiconductor lasers 1R, 1G, and 1B (FIG. 7) that emit lights of the wavelengths of red color, green color, and blue color, respectively.

Example in which a high-frequency signal having the same fundamental frequency is superimposed:

As shown in FIGS. 8, 9, and 10, the sum of an oscillation delay time period $td$ and a relaxation oscillation duration $tr$ is smallest in the semiconductor laser 1G that emits a green light, and is 2.4 nsec.

Accordingly, in a case where the high-frequency superimposition is performed on the three semiconductor lasers 1R, 1G, and 1B using the three high-frequency signals V3, V8, and V9 having the same fundamental frequency to thereby obtain the drive currents of the respective semiconductor lasers, it is necessary to prevent any of the three semiconductor lasers from oscillating in a single-mode and to set the semiconductor-laser drive period $t1$ (FIG. 2) of each of the drive currents IdR, IdG, and IdB of the semiconductor lasers to be 2.4 nsec or less based on the semiconductor laser 1G, in order to maintain a speckle-noise reduction effect.

When a semiconductor-laser non-drive period $t0$ (FIG. 2) of each of the drive currents IdR, IdG, and IdB is defined as 1 nsec, a fundamental frequency $f$ of each of the high-frequency signals V3, V8, and V9 is calculated based on the expression (2). In this case, therefore, the high-frequency signals V3, V8, and V9 having the same fundamental frequency of 294 MHz or more are required.

$$[\text{Math. 2}]$$
$$f = 1/(t1 + t0) \qquad \dots (2)$$

Here, if it is assumed that the semiconductor-laser non-drive period $t0$ of the drive current of each semiconductor laser is 1 nsec and any of the fundamental frequencies $f$ of the high-frequency signals V3, V8, and V9 corresponding to the drive currents of the respective semiconductor lasers is 294 MHz, a ratio $r$ of a time period in which each of the semiconductor lasers 1R, 1G, and 1B emits a light is obtained as the value indicated in Table 1, based on the expression (1). In Table 1, the upper row of "Red LD", "Green LD", "Blue LD", and "Average" indicate the semiconductor lasers 1R, 1G, 1B, and the average of the semiconductor lasers, respectively, and the lower row of numerical values indicate the ratios of the time periods of the respective semiconductor lasers emit lights, and the average of the ratios of the time periods in which the respective semiconductor lasers emit lights.

[Table 1]

| Red LD | Green LD | Blue LD | Average |
|--------|----------|---------|---------|
| 53% | 59% | 59% | 57% |

In a case where the semiconductor lasers are driven by using the drive currents IdR, IdG, and IdB of the semiconductor laser that are generated by superimposing the high-frequency signals V3, V8, and V9 having the same fundamental frequency on the analog voltages V1, V6, and V7, respectively, the peak of EMI becomes large at frequencies of the fundamental wave each harmonic wave of the drive current, as mentioned above.

Therefore, in an example described below, the frequency of the high-frequency signal to be used for the high-frequency superimposition for generating the drive current of each LD is selected in accordance with the response characteristics of the LD such that suppression of the EMI and suppression of a deterioration in the light emission intensity can be obtained while maintaining the speckle reduction effect in the semiconductor lasers 1R, 1G, and 1B.

Example 1 of superimposing high-frequency signals having different fundamental frequencies:

Firstly, an example of setting will be described in which a condition (also referred to as "condition 1") is satisfied that the drive currents IdR, IdG, and IdB have different fundamental frequencies, that is, the high-frequency signals V3, V8, and V9 used for high-frequency superimposition have different fundamental frequencies, and in addition a condition (also referred to as "condition 2") is satisfied that the semiconductor-laser drive period of the drive current monotonically increases sequentially from one of the semiconductor lasers 1R, 1G, and 1 B in which the sum of the oscillation delay time period and the relaxation oscillation duration is shorter.

In an exemplary case where the drive currents IdR, IdG, and IdB satisfy the conditions 1 and 2, as indicated by the response characteristics of the respective LDs shown in FIGS. 8 to 10, while the sum of the oscillation delay time period $td$ and the relaxation oscillation duration $tr$ differs among the semiconductor lasers 1R, 1G, and 1B, the frequency setting signals 12R, 12G, and 12B supplied from the image output circuit 121 are adjusted to thereby adjust the fundamental frequencies of the high-frequency signals V3, V8, and V9, so that the semiconductor-laser drive periods $t1$ of the drive currents IdR, IdG, and IdB can be set equal to the sum of the oscillation delay time period $td$ and the relaxation oscillation duration $tr$ of the corresponding semiconductor lasers, respectively. Thereby, in the response characteristics of the respective LDs shown in FIGS. 8 to 10, the semiconductor-laser drive period's $t1$ of the drive currents IdR, IdG, and IdB are 3.6 nsec, 2.4 nsec, and 2.8 nsec, respectively.

Accordingly, if the semiconductor-laser non-drive period $t0$ of each of the drive currents IdR, IdG, and IdB is set to 1 nsec similarly to the above-described example, the fundamental frequencies of the drive currents of the semiconductor lasers 1R, 1G, and 1B, that is, the fundamental frequencies f of the high-frequency signals V3, V8, and V9, are 217MHz, 294MHz, and 263MHz, respectively, based on the expression (2).

In this case, the ratio $r$ of a time period in which each of the semiconductor lasers 1R, 1G, and 1B emits a light is obtained as the value indicated in Table 2, based on the expression (1). The denotations of Table 2 are the same as those of Table 1.

[Table 2]

| Red LD | Green LD | Blue LD | Average |
|--------|----------|---------|---------|
| 65% | 59% | 63% | 62% |

Table 3 shows the fundamental frequency and each Harmonic frequency (unit: MHz) of each of the high-frequency signals V3, V8, and V9 used for the high-frequency superimposition on the analog voltages V1, V6, and V7 for generating the drive currents IdR, IdG, and IdB in this case. In Table 3, the items "Fundamental Wave" to "Seventh Harmonic Wave" represent a fundamental wave through a seventh harmonic of a high-frequency signal corresponding to each semiconductor laser, and the items "Red LD", "Green LD", and "Blue LD" represent the semiconductor lasers 1R, 1G, and 1B, respectively. In the table, the frequencies appearing in italic type represent frequencies being higher than the highest frequency among the fifth harmonic frequencies of the high-frequency signal used for high-frequency superimposition with respect to each of the semiconductor lasers 1R, 1G, and 1B.

[Table 3]

| Red LD | Red LD | Green LD | Blue LD |
|--------|--------|----------|---------|
| Fundamental Wave | 217 | 294 | 263 |
| Second Harmonic Wave | 435 | 588 | 526 |
| Third Harmonic Wave | 652 | 882 | 789 |
| Fourth Harmonic Wave | 870 | 1176 | 1053 |
| Fifth Harmonic Wave | 1087 | 1471 | 1316 |
| Sixth Harmonic Wave | 1304 | *1765* | *1579* |
| Seventh Harmonic Wave | *1522* | *2059* | *1842* |

Firstly, from Table 3, it can be found that spectrums of EMIs caused by the drive currents IdR, IdG, and IdB of the LDs are dispersed without overlapping each other at the fundamental frequencies of the respective drive currents.

That is, as shown in Table 3, the fundamental frequencies of the high-frequency signals V3, V8, and V9 paired with the semiconductor lasers 1R, 1G, and 1B, respectively, satisfy the condition 1. In other words, the fundamental frequencies of the respective high-frequency signals are set to be different from one another. Thereby, in an EMI caused by the fundamental wave and each harmonic wave of each of the drive currents IdR, IdG, and IdB that are generated by superimposition of the high-frequency signals V3, V8, and V9 on the analog voltages V1, V6, and V7, respectively; a spectrum of the EMI caused by the fundamental wave, which may produce the maximum EMI peak, is dispersed without overlap. Therefore, a peak value of the EMI caused by the fundamental waves that occur when the plurality of semiconductor lasers 1R, 1G, and 1B are driven is lowered as compared with, for example, a case where all of the high-frequency signals used for high-frequency superimposition have the same fundamental frequency. Thus, the EMI can be suppressed efficiently.

Thus, from the viewpoint of suppression of EMI, it is more desirable that high-frequency signals used for high-frequency superimposition for generating the drive currents of the plurality of LDs have different fundamental frequencies, than that all of the high-frequency signals have the same fundamental frequency.

Table 1 and Table 2 reveal the fact that, in a case of Table 2, the ratios of the time periods in which the semiconductor lasers 1R and 1B emit lights increases so that a deterioration in the average amount of total light emission from each semiconductor laser is reduced as compared with the case of Table 1 where all of the high-frequency signals V3, V8, and V9 to be superimposed on the analog voltages V1, V6, and V7 for generating the drive currents of the semiconductor lasers 1R, 1G, and 1B have the same fundamental frequency.

That is, the semiconductor lasers 1R, 1G, and 1B are set such that the semiconductor-laser drive period $t1$ of the drive current can monotonically increase sequentially from one of the semiconductor lasers 1R, 1G, and 1B in which the sum of the oscillation delay time period $td$ and the relaxation oscillation duration $tr$ is shorter. Thereby, while efficiently suppressing speckle noise in each semiconductor laser in accordance with differences in the response characteristics among the respective semiconductor lasers responsive to the drive currents, a deterioration in the light emission intensity of each LD can be reduced as shown in Table 2. In addition, a deterioration in the average amount of total light emission of each semiconductor laser can also be reduced.

Moreover, Table 3 reveals that the spectrums of the EMIs caused by the drive currents IdR, IdG, and IdB of the LDs are dispersed without overlapping each other at least up to the fifth harmonic wave.

Here, in the EMI standard, a measurement frequency range is defined as 1 GHz or lower according the VCCI standard, and as a fifth harmonic wave of the maximum frequency or lower according to the FCC standard. Therefore, in the example shown in Table 3, no frequency overlap occurs within the range defined by the VCCI standard and the FCC standard.

Merely when the high-frequency signals V3, V8, and V9 have different fundamental frequency values, an advantageous effect can be obtained. However, when the frequencies of the high-frequency signals V3, V8, and V9 are set so as not to overlap each other in a range from the fundamental wave to a predetermined-order harmonic wave, for example, up to the fifth harmonic wave, not only the spectrums of EMIs caused by the fundamental frequencies of the high-frequency signals V3, V8, and V9 but also the spectrums of EMIs caused by the harmonic frequencies up to a predetermined-order harmonic frequency are dispersed. This can further lower the peak value of the EMI caused when the plurality of semiconductor lasers 1R, 1G, and 1B are driven, to allow efficient suppression of the EMI.

Example 2 of superimposing high-frequency signals having different fundamental frequencies:

Next, an example will be shown in which the frequency of the high-frequency signal used for high-frequency superimposition is selected in accordance with the response characteristics of each LD such that a greater speckle reduction effect can be exhibited in an LD in which speckle noise tends to be prominent.

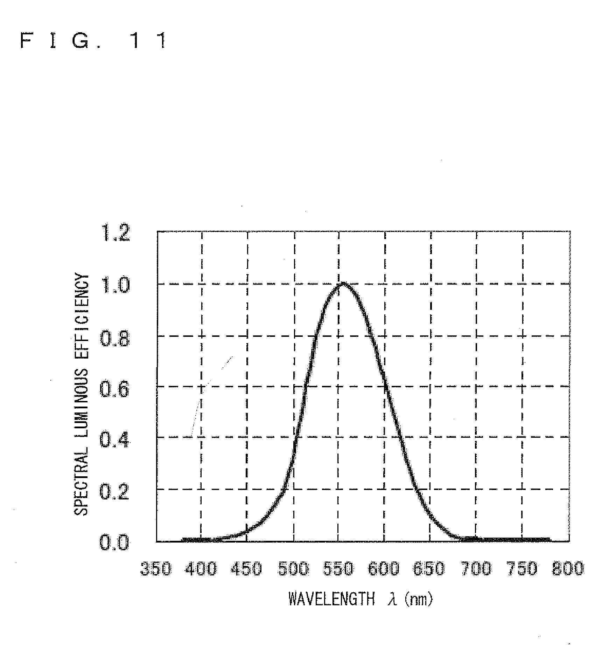

FIG. 11 is a diagram for explaining the human's spectral luminous efficiency (also referred to as "luminosity function") with respect to lights of various wavelengths. FIG. 11 reveals that, in a case of adopting LDs that emit laser beams having wavelengths of 645 nm, 532 nm, and 445 nm as a red light, a green light, and a blue light, respectively, the luminosity factors for the red light and the blue light are lower than the luminosity factor for the green light. The green light corresponding to a high luminosity factor causes the most prominent speckle noise to the human eye, and therefore it is important to reduce the speckle noise caused by the LD that emits a green-laser beam. On the other hand, in the blue laser beam having the lowest luminosity, less speckle noise is caused. Therefore, putting priority on the suppression of the deterioration in the light intensity, the semiconductor-laser drive period $t1$ (FIG. 2) of the drive current of the semiconductor laser that emits the blue light can be set to be longer than the sum of the oscillation delay time period $td$ and the relaxation oscillation duration $tr$.

Next, an example will be shown in which the frequencies of the high-frequency signals V3, V8, and V9 to be superimposed on the analog voltages V1, V6, and V7 for generating the drive currents IdR, IdG, and IdB of the respective semiconductor lasers are selected in consideration of the human's luminosity factor with respect to the semiconductor lasers 1R, 1G, and 1B that have the transient response characteristics shown in FIGS. 8 to 10 and that emit laser beams of wavelength of red-color, green-color, and the blue-color.

Here, an example of setting will be described in which the condition 1 mentioned in Example 1 is satisfied, in other words, the high-frequency signals V3, V8, and V9 used for high-frequency superimposition have different fundamental frequencies while a condition (also referred to as "condition 3") is satisfied that the semiconductor-laser drive period *t1* of the drive current monotonically increases sequentially from one of the semiconductor lasers 1R, 1G, and 1B that emits a laser beam having a wavelength to which the human's luminosity factor is higher.

The frequency setting signals 12R, 12G, and 12B supplied from the image output circuit 121 are adjusted to thereby adjust the fundamental frequencies of the high-frequency signals V3, V8, and V9, so that the semiconductor-laser drive period *t1* of each drive currents can be set equal to the sum of the oscillation delay time period *td* and the relaxation oscillation duration *tr* of each of the semiconductor lasers 1R, 1G, and 1B shown in the response characteristics of FIGS. 8 to 10. Thereby, the semiconductor-laser drive periods *t1* of the drive currents of the semiconductor lasers 1R, 1G, and 1B are 3.6 nsec, 2.4 nsec, and 2.8 nsec, respectively. Here, in order that the drive currents IdR, IdG, and IdB can satisfy the conditions 1 and 3, the semiconductor-laser drive periods *t1* of the drive currents of the semiconductor lasers 1R and 1G causing more prominent speckle noise are set to be slightly shorter for priority on the speckle-noise reduction effect, while the semiconductor-laser drive period *t1* of the semiconductor laser 1B causing less prominent speckle is set to be longer for priority on ensuring of the light intensity. In this case, for example, if time periods of 3.3 nsec, 2.2 nsec, and 4.0 nsec are adopted as the semiconductor-laser drive periods *t1* of the drive currents of the semiconductor lasers 1R, 1G, and 1B, respectively, while a time period of 1 nsec is adopted as the semiconductor-laser non-drive period *t0* of each drive current; the fundamental frequencies of the drive currents of the semiconductor lasers 1R, 1G, and 1B, that is, the fundamental frequencies f of the high-frequency signals V3, V8, and V9, are 233 MHz, 313 MHz, and 200 MHz, respectively, based on the expression (2).

In this case, the ratio *r* of a time period in which each of the semiconductor lasers 1R, 1G, and 1B emits a light is obtained as the value indicated in Table 4, based on the expression (1). The denotations of Table 4 are the same as those of Table 1.

[Table 4]

| Red LD | Green LD | Blue LD | Average |
| --- | --- | --- | --- |
| 63% | 56% | 72% | 64% |

Table 5 shows the fundamental frequency and each harmonic frequency (unit: MHz) of each of the high-frequency signals V3, V8, and V9 used for the high-frequency superimposition on the analog voltages V1, V6, and V7 for generating the drive currents IdR, IdG, and IdB in this case. The denotations of Table 5 are the same as those of Table 3.

[Table 5]

| Red LD | Red LD | Green LD | Blue LD |
| --- | --- | --- | --- |
| Fundamental Wave | 233 | 313 | 200 |
| Second Harmonic Wave | 465 | 625 | 400 |
| Third Harmonic Wave | 698 | 928 | 600 |
| Fourth Harmonic Wave | 930 | 1250 | 800 |
| Fifth Harmonic Wave | 1163 | 1563 | 1000 |
| Sixth Harmonic Wave | 1395 | *1875* | 1200 |
| Seventh Harmonic Wave | *1628* | *2188* | 1400 |
| Eighth Harmonic Wave | *1860* | *2500* | *1600* |

Firstly, from Table 5, it can be found that spectrums of EMIs caused by the drive currents IdR, IdG, and IdB of the LDs are dispersed without overlapping each other at the fundamental frequencies of the respective drive currents.

This is, similarly to the result shown in Table 3 in Example 1, because of the following. That is, the fundamental frequencies of the high-frequency signals V3, V8, and V9 paired with the semiconductor lasers 1R, 1G, and 1B, respectively, satisfy the condition 1, and in other words, they are set to be different from one another. Thereby, in an EMI caused by the fundamental wave and each harmonic wave of each of the drive currents IdR, IdG, and IdB that are generated by superimposition of the high-frequency signals V3, V8, and V9, respectively; a spectrum of the EMI caused by the fundamental wave, which may produce the maximum EMI peak, is dispersed without overlap. Therefore, a peak value of the EMI caused by the fundamental waves that occur when the plurality of semiconductor lasers 1R, 1G, and 1B are driven is lowered as compared with a case where all of the high-frequency signals used for high-frequency superimposition have the same fundamental frequency. Thus, the EMI can be suppressed efficiently.

Thus, from the viewpoint of suppression of EMI, it is more desirable that high-frequency signals used for high-frequency superimposition have different fundamental frequencies, than that all of the high-frequency signals have the same fundamental frequency.

As shown in Table 2 and Table 4, regarding the semiconductor lasers 1R and 1G, the ratio of the light-emission time period is shorter in the result shown in Table 4 than in the result shown in Table 2 because of priority on the speckle-noise reduction effect, while regarding the semiconductor laser 1B, the ratio of the light-emission time period is performed increases in the result shown in Table 4 as compared with the result shown in Table 2 because of priority on increase in the ratio of the light-emission time period.

From Table 1 and Table 4, it can be found that an average deterioration in the light emission intensity of the semiconductor lasers can be reduced in Table 4 showing the result of setting the fundamental frequencies of the high-frequency signals used for high-frequency superimposition for the respective semiconductor lasers such that visual speckle noise can be reduced in consideration of the human's luminosity factor to the wavelength of the laser beam emitted from each semiconductor laser, as compared with Table 1 showing the result of setting the fundamental frequencies of the high-frequency signals V3, V8, and V9 to be superimposed on the analog voltages V1, V6, and V7 for generating the drive currents of the semiconductor lasers 1R, 1G, and 1B such that all of them can have the same fundamental frequency.

That is, the setting is made such that the semiconductor-laser drive period $t1$ of the drive current can monotonically increase sequentially from one of the semiconductor lasers 1R, 1G, and 1B that emits a laser beam having a wavelength to which the human's luminosity factor is higher. Thereby, in accordance with the human's luminosity factor to the wavelength of the laser beam emitted from each semiconductor laser, the visual speckle noise of each semiconductor laser can be suppressed in an efficient manner while a deterioration in an average amount of light emission of each semiconductor laser can also be reduced as shown in Table 4.

Moreover, Table 5 reveals that the spectrums of the EMIs caused by the drive currents IdR, IdG, and IdB of the LDs are dispersed without overlapping each other at least up to the fifth harmonic wave.

Therefore, in the example shown in Table 5, similarly to the result shown in Table 3 of Example 1, no frequency overlap occurs within the range defined by the VCCI standard and the FCC standard.

Merely when the high-frequency signals V3, V8, and V9 have different fundamental frequency values, an advantageous effect can be obtained. However, when the frequencies of the high-frequency signals V3, V8, and V9 are set so as not to overlap each other in a range from the fundamental wave to a predetermined-order harmonic wave, for example, up to the fifth harmonic wave, not only the spectrums of EMIs caused by the fundamental frequencies of the high-frequency signals V3, V8, and V9 but also the spectrums of EMIs caused by the harmonic frequencies up to a predetermined-order harmonic frequency are dispersed. This can further lower the peak value of the EMI caused when the plurality of semiconductor lasers 1R, 1G, and 1B are driven, to allow efficient suppression of the EMI.

Although there is no overlap at the Harmonic wave of the drive signal of each LD in Example 1 and Example 2, overlap may occur in the fundamental wave or the harmonic wave depending on the transient response characteristics of an LD used. In such a case, if the EMI arises a problem at the frequency where the overlap occurs, frequency overlap can be avoided by shifting a drive frequency for any of LDs causing the frequency overlap. Here, which of the LDs should be the target of changing the frequency of the high-frequency signal corresponding to the drive current may be appropriately set in consideration of the speckle-noise reduction effect and a deterioration in the light emission intensity.

Although in Example 1, the frequency of the high-frequency signal to be superimposed in each LD is selected such that the semiconductor-laser drive period $t1$ can be equal to the sum of the oscillation delay time period $td$ and the relaxation oscillation duration $tr$, the frequency of the high-frequency signal for each LD may be adjusted in accordance with a demand concerning the speckle-noise reduction effect and the light emission intensity.

In the same manner, in Example, the frequency of the high-frequency signal for each LD may be adjusted in accordance with a demand concerning the speckle-noise reduction effect and the light emission intensity.

DESCRIPTION OF THE REFERENCE NUMERALS

1R, 1G, 1B semiconductor laser
2R, 2G, 2B collimator lens
3 combining section
3R, 3G, 3B dichroic mirror
4, 5, 6 D/A converter
7 analog switch
8 voltage control oscillator

9 LD driver
10 bias current source
11R, 11G, 11B pixel data signal
12R, 12G, 12B frequency setting signal
13R, 13G, 13B bias-current setting signal
14 light-receiving element
100 image projection apparatus
110 input-image processing section
111 image input circuit
112 image processing circuit
120 drive control section
121 image output circuit
122 deflection control circuit
123 light-source drive section
124 frame memory
125 sensor-output processing circuit
130 optical mechanism section
132 two-dimensional deflection section
132a deflection scanning mirror
133 laser light source section
IM input device
SC screen

**Claims**

1. An image display apparatus for displaying image on a projection surface, said image display apparatus comprising:

   a plurality of semiconductor lasers for emitting laser beams of different wavelengths in accordance with drive currents supplied thereto;
   a laser-drive circuit for generating said drive currents by superimposing a plurality of high-frequency signals on image signals of a plurality of color components, respectively; and
   deflection means for deflecting each of said laser beams,
   wherein said plurality of high-frequency signals have different fundamental frequencies.

2. The image display apparatus according to claim 1, wherein
   for said plurality of semiconductor lasers, a semiconductor-laser drive period of each of said drive currents is set so as to monotonically increase sequentially from one of said plurality of semiconductor lasers in which the sum of an oscillation delay time period and a relaxation oscillation duration is shorter.

3. The image display apparatus according to claim 1, wherein
   for said plurality of semiconductor lasers, a semiconductor-laser drive period of each of said drive currents is set so as to be equal to the sum of an oscillation delay time period and a relaxation oscillation duration.

4. The image display apparatus according to claim 1, wherein
   for said plurality of semiconductor lasers, a semiconductor-laser drive period of each of said drive currents is set so as to monotonically increase sequentially from one of said plurality of semiconductor lasers that emits the laser beam having a wavelength to which human's luminosity factor is higher.

5. The image display apparatus according to claim 1, wherein
   said plurality of high-frequency signals have different harmonic frequencies from one another in a range up to a predetermined-order harmonic.

6. A laser projection apparatus for projecting a laser beam, comprising:

   a plurality of semiconductor lasers for emitting laser beams of different wavelengths in accordance with drive currents supplied thereto; and
   a laser-drive circuit for generating said drive currents by superimposing a plurality of high-frequency signals on image signals of a plurality of color components, respectively,
wherein said plurality of high-frequency signals have different fundamental frequencies.

7.  A laser projection apparatus for projecting a laser beam, comprising:

a plurality of semiconductor lasers for emitting laser beams of different wavelengths in accordance with drive currents supplied thereto; and
a laser-drive circuit for generating each of said drive currents that serve as cycle signals, such that a semiconductor-laser drive period of each of said drive current can be equal to the sum of an oscillation delay time period and a relaxation oscillation duration corresponding to each of said plurality of semiconductor laser, wherein
each of said drive currents is generated based on a high-frequency signal and an image signal corresponding to each of said plurality of semiconductor lasers,
said drive currents have different cycles.

F I G . 1

F I G . 2

FIG. 3

FIG. 4

FIG. 5

FIG. 6

F I G. 7

FIG. 8

FIG. 9

FIG. 10

EP 2 426 545 A1

F I G . 1 1

24

## INTERNATIONAL SEARCH REPORT

| | International application No. |
|---|---|
| | PCT/JP2010/054289 |

| A. CLASSIFICATION OF SUBJECT MATTER |
|---|
| *G02B27/48*(2006.01)i, *G02B27/18*(2006.01)i, *G03B21/14*(2006.01)i |

According to International Patent Classification (IPC) or to both national classification and IPC

| B. FIELDS SEARCHED |
|---|
| Minimum documentation searched (classification system followed by classification symbols) |
| G02B27/48, G02B27/18, G03B21/14, G09G3/02, G02B26/10, H01S5/042 |

Documentation searched other than minimum documentation to the extent that such documents are included in the fields searched

| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| A | JP 2001-189520 A  (Sony Corp.),<br>10 July 2001 (10.07.2001),<br>entire text; all drawings<br>(Family: none) | 1-7 |
| A | WO 2005/083492 A1  (Matsushita Electric Industrial Co., Ltd.),<br>09 September 2005 (09.09.2005),<br>entire text; all drawings<br>& US 2008/0170285 A1    & EP 1720057 A1<br>& CN 1820220 A | 1-7 |
| A | WO 1996/038757 A1  (Matsushita Electric Industrial Co., Ltd.),<br>05 December 1996 (05.12.1996),<br>entire text; all drawings<br>& US 6333943 B1          & CN 1190472 A | 1-7 |

☐ Further documents are listed in the continuation of Box C.　　☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 08 June, 2010 (08.06.10) | 22 June, 2010 (22.06.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**EP 2 426 545 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2001189520 A
- JP 2004070286 A
- JP 2006343663 A